Europäisches Patentamt

European Patent Office

Office européen des brevets

(11) Veröffentlichungsnummer: **0 422 273 A1**

## EUROPÄISCHE PATENTANMELDUNG

(21) Anmeldenummer: 89118996.1

(22) Anmeldetag: 12.10.89

(51) Int. Cl.⁵: **H03K 5/156**

(43) Veröffentlichungstag der Anmeldung:
**17.04.91 Patentblatt 91/16**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Preller, Peter, Dipl.-Ing.**
**Heinrich-Schütz-Weg 5**
**W-8000 München 60(DE)**

(54) Schaltungsanordnung zur Tastverhältnisregelung.

(57) Das Tastverhältnis eines Eingangssignals wird durch die erfindungsgemäße Schaltungsanordnung auf einen vorgegebenen Wert eingeregelt. Ein Kondensator (4) wird über eine Diode (3) mit durch einen Differenzierer (2) gebildeten Impulsen aufgeladen. Ein nachfolgender Komparator (5) bildet ein Ausgangssignal, dessen Tastverhältnis durch eine Regelschaltung (7) gemessen wird. Die Regelschaltung steuert den Entladestrom $I_C$ des Kondensators (4) und damit das Tastverhältnis des Ausgangssignals. Die Regelung ist unabhängig von Frequenz und Tastverhältnis des Eingangssignals sowie unabhängig von Schwankungen der Versorgungsspannung, der Temperatur sowie der ausgangsseitigen Belastungen.

Die erfindungsgemäße Schaltungsanordnung kann in allen integrierten Schaltungen mit Takteingang Anwendung finden.

FIG 1

EP 0 422 273 A1

## SCHALTUNGSANORDNUNG ZUR TASTVERHÄLTNISREGELUNG.

Die Erfindung betrifft eine Schaltungsanordnung zur Tastverhältnisregelung.

Oftmals ist es notwendig, daß das Tastverhältnis eines zu verarbeitenden impulsförmigen Signals in einem definierten Bereich liegt, um von nachfolgenden Schaltungen verarbeitet werden zu können. Dieser Bereich ist in einigen integrierten Schaltungen sehr eng toleriert und läßt sich nur unter großen Schwierigkeiten einhalten. Um derartige Einschränkungen zu vermeiden, kann man einen Tastverhältnisregler vorschalten.

Eine Möglichkeit zur Regelung des Tastverhältnisses bietet z.B. eine PLL-Schaltung aus ELrad Heft 12/1988, S.85ff. Ein Oszillator erzeugt ein Ausgangssignal, das in Frequenz und Phase mit dem Eingangssignal übereinstimmt. Das Tastverhältnis des Ausgangssignals ist unabhängig vom Tastverhältnis des Eingangssignals und wird nur durch den Oszillator bestimmt. Die Frequenz des Eingangssignals darf aber nur innerhalb des von der PLL-Schaltung fangbaren Frequenzbereichs variieren. Außerdem ist das Tastverhältnis von Temperatur, Versorgungsspannung, Frequenz und ausgangsseitiger Belastung abhängig.

Aufgabe der vorliegenden Erfindung ist es, eine Schaltungsanordnung zur Tastverhältnisregelung anzugeben, die das Tastverhältnis eines impulsförmigen Eingangssignals unabhängig von Frequenz und Tastverhältnis des Eingangssignals sowie unabhängig von Temperatur, Versorgungsspannung und ausgangsseitiger Belastung regelt.

Diese Aufgabe wird durch die kennzeichnenden Merkmale des Anspruchs 1 gelöst. weiterbildungen der Erfindung sind Kennzeichen der Unteransprüche.

Die Erfindung wird im folgenden anhand von insgesamt sechs Figuren näher erläutert. Es zeigen:

FIG 1 bis 4 Prinzipschaltungsanordnungen gemäß der Erfindung.

FIG 5, 6 einen zeitlichen Verlauf von fünf Signalen der in den Figuren 1 bis 4 gezeigten Schaltungsanordnungen,

FIG 7 ein Ausführungsbeispiel der erfindungsgemäßen Schaltungsanordnung nach FIG 3.

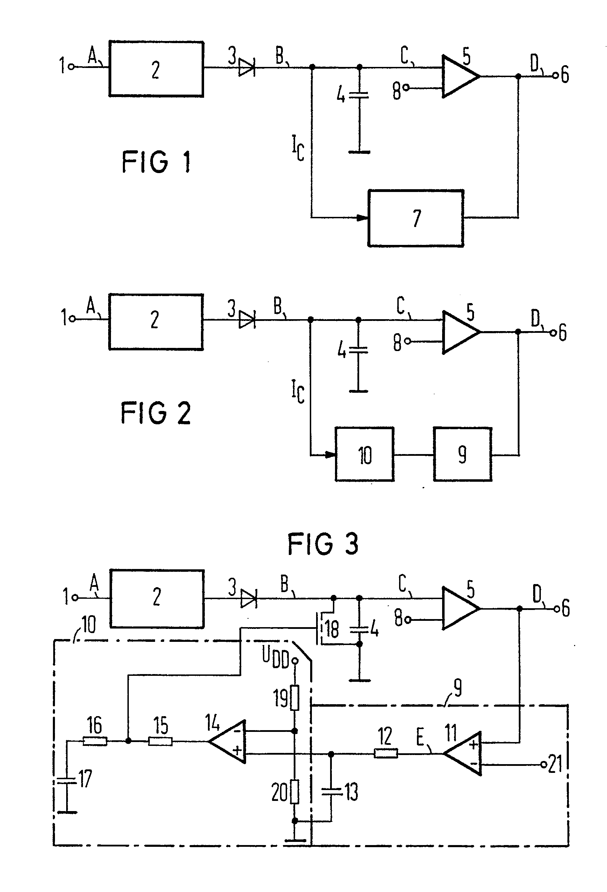

FIG 1 zeigt eine Prinzipschaltungsanordnung gemäß der Erfindung. Eine erste Eingangsklemme 1 ist mit dem Eingang eines Differenzierers 2 verbunden. Der Ausgang des Differenzierers 2 ist über eine Diode 3 mit dem ersten Anschluß eines Kondensators und dem ersten Eingang eines Komparators 5 verbunden. Der zweite Anschluß des Kondensators 4 ist mit einem festen Potential (z.B. Masse) verbunden. Am zweiten Eingang 8 des Komparators 5 liegt eine Referenzspannung an.

Der Ausgang des Komparators 5 ist zum einen mit einer Ausgangsklemme 6 und zum anderen mit dem Eingang einer Regelschaltung 7 verbunden. Der Ausgang der Regelschaltung 7 ist mit dem ersten Anschluß des Kondensators 4 verbunden.

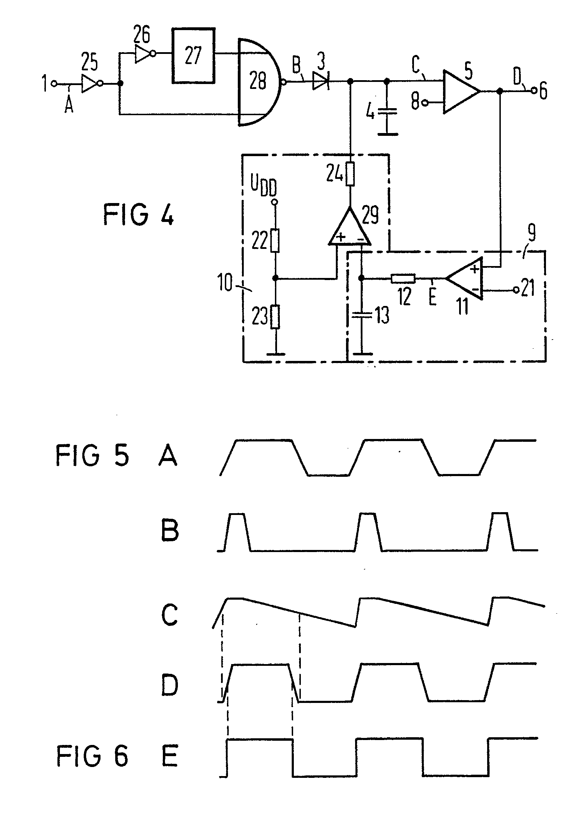

In Verbindung mit FIG 5, die einen zeitlichen Verlauf von vier Signalen an den Punkten A bis D der Schaltungsanordnung in FIG 1 zeigt, wird nun die Funktionsweise der Prinzipschaltung näher erläutert. An der Eingangsklemme 1 liegt ein impulsförmiges Eingangssignal an und gelangt zum Eingang des Differenzierers 2. Dieses Signal ist in FIG 5 mit A bezeichnet. Der Differenzierer 2 formt nun kurze Impulse aus den positiven Flanken (in FIG 5 mit B bezeichnet), deren Impulslängen unabhängig vom Tastverhältnis des Eingangssignals sind. Über die Diode 3 wird nun mit jedem Impuls der Kondensator 4 aufgeladen. Der Kondensator 4 wird durch den durch die Regelschaltung 7 eingestellten Strom $I_c$ entladen. Der zeitliche Verlauf der Spannung am Kondensator 4 ist in FIG 5 mit C bezeichnet. Der Komparator 5 vergleicht nun die Spannung am Kondensator 4 mit einer Referenzspannung, die am zweiten Eingang 8 des Komparators 5 anliegt. Der Komparator 5 könnte aber auch durch eine in Sättigung betriebene Treiberstufe ersetzt werden. An der Ausgangsklemme 6 liegt nun wieder ein impulsförmiges Signal an. Der zeitliche Verlauf dieses Signals ist in FIG 5 mit D bezeichnet. Die Regelschaltung 7 stellt nun in Abhängigkeit vom Tastverhältnis des Ausgangssignals des Komparators 5 den Entladestrom $I_C$ des Kondensators 4 ein und regelt so das Tastverhältnis des Ausgangssignals auf einen innerhalb der Regelschaltung 7 definierten Wert ein.

Die in FIG 2 gezeigte Prinzipschaltungsanordnung unterscheidet sich von der in FIG 1 gezeigten lediglich durch eine detailliertere Darstellung der Regelschaltung. Alle in FIG 1 verwendeten Bezugszeichen stehen deshalb für die gleichen Schaltungskomponenten. Die Regelschaltung 7 ist in zwei Blöcke 9, 10 aufgeteilt. Block 9 enthält eine Meßschaltung, die eine zum Tastverhältnis des am Ausgang des Komparators 5 anliegenden Signals proportionale Spannung erzeugt. Block 10 enthält eine Steuerschaltung, die in Abhängigkeit der Ausgangsspannung der Meßschaltung 9 den Entladestrom $I_C$ des Kondensators 4 steuert. Die Funktion der in FIG 2 gezeigten Prinzipschaltungsanordnung entspricht der in FIG 1 gezeigten.

FIG 3 zeigt eine zu FIG 2 identische Prinzipschaltungsanordnung mit einer möglichen Realisierung der Blöcke 9, 10. Alle bisher bekannten Bezugszeichen aus FIG 1 und FIG 2 stehen wieder für die gleichen Schaltungskomponenten. Die Meßschaltung 9 wird durch einen Komparator 11 mit nachgeschaltetem Tiefpaß 12, 13 gebildet.

Der Komparator 11 vergleicht die Ausgangsspannung des Komparators 5 mit einer an der Klemme 21 anliegenden Referenzspannung und bildet ein steilflankiges Signal. Der zeitliche Verlauf dieses Signals ist in FIG 6 mit E bezeichnet. Dieses steilflankige Signal liegt am Eingang des Tiefpasses 12, 13 an. Der Tiefpaß wird durch einen Widerstand 12 und einen Kondensator 13 gebildet.

Der Eingang des Tiefpasses 12, 13 ist mit dem ersten Anschluß des Widerstands 12 verbunden, der Ausgang des Tiefpasses 12, 13 mit dem zweiten Anschluß des Widerstands 12. Der erste Anschluß des Kondensators 13 ist mit dem zweiten Anschluß des Widerstands 12 und der zweite Anschluß des Kondensators 13 ist mit einem festen Potential (z.B. Masse) verbunden.

Der Kondensator 13 wird nun von den Impulsen des Ausgangssignals des Komparators 11 aufgeladen. Dadurch entsteht am Kondensator 13 eine dem Tastverhältnis des Ausgangssignals des Komparators 11 proportionale Ausgangsspannung. Beträgt das Tastverhältnis z.B. 50%, so liegt am Kondensator 13 des Tiefpasses die halbe Ausgangsspannung an.

Die Steuerschaltung 10 wird in FIG 3 durch einen weiteren Komparator 14, einen weiteren nachgeschalteten Tiefpaß 15, 16, 17 und einen Enhancement-MOSFET 18 gebildet. Am ersten Eingang des Komparators 14 liegt die vom Tiefpaß 12, 13 erzeugte Ausgangsspannung und am zweiten Eingang des Komparators eine durch einen Spannungsteiler 19, 20 festgelegte Referenzspannung an. Der dem Komparator 14 nachgeschaltete Tiefpaß 15, 16, 17 besteht aus zwei im Reihe geschalteten Widerständen 15, 16, die über einen Kondensator 17 mit einem festen Potential (z.B. Masse) verbunden sind. Die Reihenschaltung der Widerstände 15, 16 ist mit einem Mittelabgriff versehen, der mit dem Gate-Anschluß des MOSFET 18 verbunden ist. Die Laststrecke des MOSFET 18 ist parallel zum Kondensator 4 geschaltet.

Die durch den Spannungsteiler 19, 20 vorgegebene Referenzspannung bestimmt das Tastverhältnis des an der Ausgangsklemme 6 abgreifbaren Ausgangssignals. Diese Referenzspannung wird mit der Ausgangsspannung des Tiefpasses 12, 13 verglichen. Das Ausgangssignal des Komparators 14 gelangt über den Tiefpaß 15, 16, 17 zum Gate-Anschluß des Transistors 18. Über dessen Laststrecke fließt nun in Abhängigkeit von der Gate-Spannung der Entladestrom $I_C$ des Kondensators 4. Auf diese Weise wird das Tastverhältnis des Ausgangssignals des Komparators 5 auf einen zur Referenzspannung am Komparator 14 proportionalen Wert eingeregelt. Der dem Komparator 14 nachgeschaltete Tiefpaß 15, 16, 17 verhindert, daß der Regelkreis schwingt, er kann aber bei entsprechender Dimensionierung der Schaltung auch entfallen. Der Widerstand 16 dient als zusätzliches Dämpfungsglied des Tiefpasses 15, 16, 17.

FIG 4 zeigt eine bis auf die Steuerschaltung 10 zu FIG 3 identische Schaltungsanordnung. Sie unterscheidet sich lediglich durch eine weitere mögliche Realisierung der Steuerschaltung 10 und zusätzlich durch eine mögliche Realisierung des Differenzierers 2. Die Steuerschaltung 10 wird hier durch einen Komparator 29 und einen nachgeschalteten Widerstand 24 gebildet. Am ersten Eingang des Komparators 29 liegt das Ausgangssignal des Tiefpasses 12, 13 an. Am zweiten Eingangs des Komparators 29 liegt wiederum eine an einem Spannungsteiler 22, 23 abgegriffene Referenzspannung an. Der Ausgang des Komparators 29 ist über den Widerstand 24 mit dem ersten Anschluß des Kondensators 4 verbunden.

Im Vergleich zu der in FIG 3 gezeigten Steuerschaltung 10 wird hier der Komparator 29 invers betrieben. Dadurch wird der Entladestrom $I_C$ über den dem Komparator 29 nachgeschalteten Widerstand 24 direkt geregelt.

Der Differenzierer 2 wird in FIG 4 durch zwei Inverter 25, 26, ein Laufzeitglied 27 und ein NOR-Gatter 28 gebildet. Der Eingang des Differenzierers 2 ist mit dem Eingang des ersten Inverters 25 verbunden. Dessen Ausgang ist zum einen mit dem Eingang des zweiten Inverters 26 und zum anderen mit dem ersten Eingang des NOR-Gatters 28 verbunden. Der Ausgang des zweiten Inverters 26 ist über ein Laufzeitglied 27 mit dem zweiten Eingang des NOR-Gatters 28 verbunden. Am Ausgang des NOR-Gatters 28 ist das Ausgangssignal des Differenzierers 2 abgreifbar.

Das Ausgangssignal des Differenzierers 2 wird nur durch die steigende Flanke des Eingangssignals bestimmt. Die Dauer der Ausgangsimpulse ist durch das Laufzeitglied 27 festgelegt.

FIG 5 zeigt zeitliche Signalverläufe an den Punkten A bis D der in den Figuren 1 bis 4 dargestellten Schaltungsanordnungen. Die gestrichelt gezeichneten Linien markieren die Schwelle des Komparators 5, die durch die Referenzspannung am Eingang 8 vorgegeben ist.

FIG 6 zeigt einen zeitlichen Signalverlauf am Punkt E der Figuren 3 und 4. Die gestrichelt gezeichneten Linien markieren die Schwelle des Komparators 11 mit der an 21 anliegenden Referenzspannung.

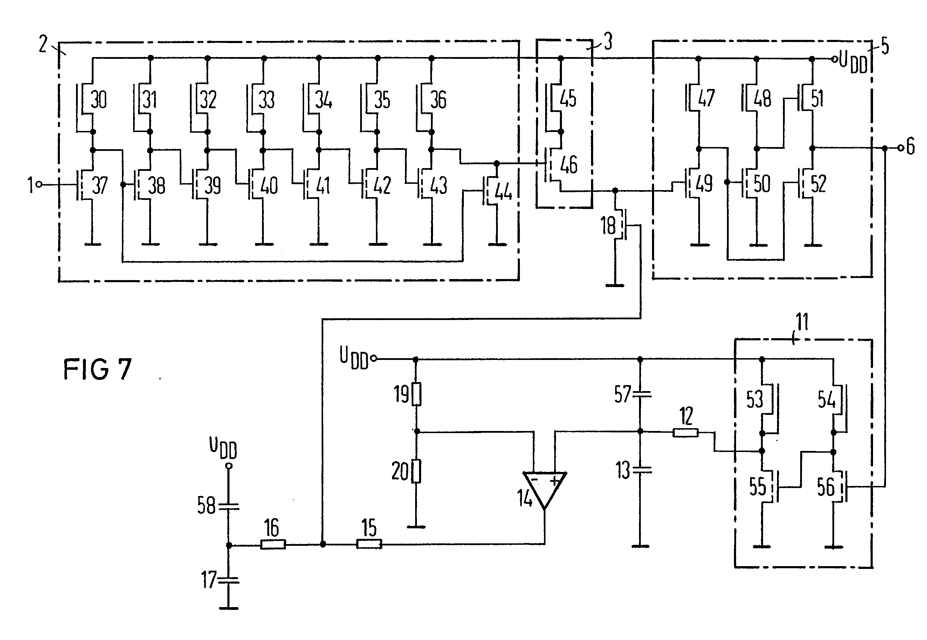

Eine im einzelnen dargestellte und integrierbare erfindungsgemäße Schaltungsanordnung gemäß der Prinzipschaltung in FIG 3 zeigt FIG 7. Die in MOS-Technologie realisierte Schaltungsanordnung weist einen Differenzierer 2 mit einem als Inverter 25 betriebenen Enhancement-MOSFET 37, einen als Inverter 26 betriebenen MOSFET 38 und einen aus einer geradzahligen Anzahl, hier z.B. vier, Enhancement-MOSFETs 39.... 42 bestehenden Verzögerungsglied sowie ein durch zwei Enhancement-MOSFETs 43 und 44 gebildetes NOR-Gatter auf. Die ersten Anschlüsse der Laststrecken der Enhancement-MOSFETs 37... 42 sind über als Widerstände geschaltete Depletion-MOS-FETs 30... 35 mit der Versorgungsspannung $U_{DD}$ und die zweiten Anschlüsse der Laststrecken mit Masse verbunden. Die Reihenschaltungen der Laststrecken der Enhancement-MOSFETs und der Widerstände sind mit einem Mittelabgriff versehen, der mit dem Gate-Anschluß des jeweils nachfolgenden Enhancement-MOS-FETs verbunden ist. Das NOR-Gatter wird durch die beiden Enhancement-MOSFETs 43 und 44 gebildet. Eine Laststrecke des NOR-Gatters liegt als Depletion-MOSFET 36 zwischen den verbundenen Drain-Anschlüssen der MOSFETs 43, 44 und $U_{DD}$. Der Ausgang des Verzögerers ist zum einen über die Laststrecken des MOSFET 43, 44 mit Masse und zum anderen mit dem Ausgang des Differenzierers 2 verbunden. Der Gate-Anschluß des MOSFET 44 ist mit dem Ausgang des Inverters 25 verbunden. Die Diode 3 wird hier ersetzt durch den als Schalttransistor wirkenden Enhancement-MOSFET 46. Der erste Anschluß seiner Laststrecke ist über einen als Widerstand geschalteten Depletion-MOSFET 45 mit der Versorgungsspannung verbunden. Der andere Anschluß der Laststrecke ist mit dem Eingang des Komparators 5 verbunden. Da für den Kondensator 4 nur eine sehr geringe Kapazität erforderlich ist, genügen die parasitären Kapazitäten, die durch die Gate-Source-Kapazität des nachfolgenden Enhancement-MOSFET 49 des Komparators 5 und die Leitungskapazitäten sowie durch die Drain-Source-Kapazität des MOSFET 46 gebildet wird. Der Komparator ist mit zwei in Reihe geschalteten Verstärkerstufen versehen, die durch einen Enhancement-MOSFET 49; 50 und einen als Widerstand geschalteten Depletion-MOSFET 47; 48 gebildet werden. Der erste Anschluß der Laststrecke eines Enhancement-MOSFETs 49; 50 ist über den Widerstand 47; 48 mit der Versorgungsspannung verbunden. Der andere Anschluß der Laststrecke des Enhancement-MOSFET 49; 50 ist mit Masse verbunden. Die Reihenschaltung des MOSFET 49; 50 und des Widerstands 47; 48 ist mit einem Mittelabgriff versehen, der mit dem Gate-Anschluß des MOSFET der nachfolgenden Verstärkerstufe verbunden ist. Die Ausgänge der ersten und der zweiten Verstärkerstufe sind mit einer durch die Enhancement-MOSFET 51, 52 gebildeten Gegentaktendstufe verbunden. Der Ausgang der Gegentaktendstufe 51, 52 ist mit der Ausgangsklemme 6 verbunden. Der Konmparator 11 ist in gleicher Weise wie der Komparator 5 aus den Enhancement-MOSFET 55; 56 und den als Widerständen geschalteten Depletion-MOSFET 53; 54 aufgebaut. Eine Gegentaktendstufe ist hier wegen des genügend großen Eingangssignalpegels nicht notwendig. Die restliche Schaltung entspricht der in FIG 3 beschriebenen. Zusätzlich sind an dem Tiefpaß Kondensatoren 57, 58 vorgesehen, deren erster Anschluß mit der Versorgungsspannung und deren zweiter Anschluß mit dem Mittelabgriff der Reihenschaltung des Widerstands 12; 16 und Kondensators 13; 17 verbunden ist. Dadurch wird gewährleistet, daß am Ausgang des Tiefpasses beim Einschalten der Versorgungsspannung die halbe Versorgungsspannung anliegt und sich so ein Tastverhältnis mit einem Anfangswert von 50% einstellt.

Die Funktionsweise des in FIG 7 dargestellten Ausführungsbeispiels entspricht der in FIG 3 beschriebenen.

Die erfindungsgemäßen Schaltungsanordnungen in FIG 1, 2, 3, 4, 7 weisen den Vorteil auf, daß das Tastverhältnis unabhängig von Frequenz und Tastverhältnis des Eingangssignals ist. Ebenso werden Schwankungen gegeben durch Temperaturänderung, Schwankungen der Versorgungsspannung und durch verschiedene ausgangsseitige Belastungen durch die Regelschaltung kompensiert.

## Ansprüche

1. Schaltungsanordnung zur Tastverhältnisregelung,
**gekennzeichnet** durch
  a) einen Differenzierer (2), an dem impulsförmige Eingangssignale anliegen,
  b) eine dem Differenzierer (2) nachgeschaltete Diode (3),
  c) einen Kondensator (4), dessen erster Anschluß mit der Diode (3) verbunden ist und an dessen zweiten Anschluß ein festes Potential anliegt,
  d) einen Komparator (5), der die am Kondensator (4) anliegende Spannung mit einer Referenzspannung vergleicht und als Ausgangssignal eine Impulsfolge erzeugt, deren Tastverhältnis vom Entladestrom $I_c$ des Kondensators (4) abhängig ist,
  e) eine Regelschaltung (7), die in Abhängigkeit vom Tastverhältnis des Ausgangssignals des Komparators (5) den Entladestrom $I_C$ des Kondensators (4) einstellt.

2. Schaltungsanordnung zur Tastverhältnisregelung nach Anspruch 1,
**dadurch gekennzeichnet,**
daß die Regelschaltung (7)
  a) eine Meßschaltung (9) enthält, die eine dem Tastverhältnis des vom Komparator (5) erzeugten Ausgangssignals proportionale Ausgangsspannung erzeugt,

b) eine Steuerschaltung (10) enthält, die in Abhängigkeit der Ausgangsspannung der Meßschaltung (9) den Entladestrom des Kondensators (4) steuert.

3. Schaltungsanordnung zur Tastverhältnisregelung nach Anspruch 2,

**dadurch gekennzeichnet,**

daß die Meßschaltung (9)

a) einen zweiten Komparator (11) enthält, der das Ausgangssignal des ersten Komparators (5) mit einer Referenzspannung vergleicht und ein Ausgangssignal erzeugt,

b) einen dem zweiten Komparator (11) nachgeschalteten ersten Tiefpaß (12, 13) enthält, der ein Ausgangssignal erzeugt.

4. Schaltungsanordnung zur Tastverhältnisregelung nach Anspruch 2,

**dadurch gekennzeichnet,**

daß die Steuerschaltung (10)

a) einen dritten Komparator (14) enthält, der das Ausgangssignal der Meßschaltung (9) mit einer Referenzspannung vergleicht,

b) einen dem dritten Komparator (14) nachgeschalteten Tiefpaß (15, 16, 17) enthält, der ein Ausgangssignal erzeugt,

c) ein steuerbares Halbleiterbauelement enthält, dessen Steueranschluß das Ausgangssignal des Tiefpasses zugeführt wird und dessen Laststrecke parallel zum Kondensator (4) geschaltet ist,

5. Schaltungsanordnung zur Tastverhältnisregelung nach Anspruch 2, **gekennzeichnet** durch eine Steuerschaltung (10) mit

a) einem dritten Komparator, der die Ausgangsspannung der Meßschaltung (9) mit einer gegebenen Referenzspannung vergleicht und eine Ausgangsspannung erzeugt, die an einem Ausgang abgreifbar ist,

b) einem Widerstand, dessen erster Anschluß mit dem ersten Anschluß des Kondensators (4) verbunden ist, und dessen zweiter Anschluß mit dem Ausgang des Komparators verbunden ist.

6. Schaltungsanordnung zur Tastverhältnisregelung nach Anspruch 1,

**dadurch gekennzeichnet,**

daß der Differenzierer (2) durch zwei Inverter (25, 26) eine Verzögerungsleitung (27) und ein NOR-Gatter (28) gebildet wird, derart daß

a) der Eingang des Differenzierers (2) mit dem Eingang des ersten Inverters (25) verbunden ist,

b) der Ausgang des ersten Inverters (25) über den zweiten Inverter (26) mit dem Eingang der Verzögerungsleitung (27) verbunden ist,

c) der Ausgang des ersten Inverters (25) mit dem ersten Eingang des NOR-Gatters (28) verbunden ist,

d) der Ausgang der Verzögerungsleitung (27) mit dem zweiten Eingang des NOR-Gatters (28) verbunden ist,

e) der Ausgang des NOR-Gatters (28) mit dem Ausgang des Differenzierers (2) verbunden ist.

FIG 1

FIG 2

FIG 3

FIG 4

FIG 5   A

FIG 5   B

FIG 5   C

FIG 5   D

FIG 6   E

FIG 7

EP 0 422 273 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | IBM TECHNICAL DISCLOSURE BULLETIN, Band 14, Nr. 6, November 1971, Seiten 1838-1839, New York, US; F.W. NICCORE: "Phase-lock loop with constant duty cycle" * Fig.; Seiten 1838-1839 * --- | 1,2 | H 03 K 5/156 |
| A | US-A-4 239 992 (PERKINS) * Figuren 1,2,4,5; Spalte 2, Zeile 43 - Spalte 5, Zeile 62 * --- | 1,2 | |
| A | DE-A-2 240 189 (LICENTIA PATENT) ----- | 1 | |

RECHERCHIERTE SACHGEBIETE (Int. Cl.5)

H 03 K

Der vorliegende Recherchenbericht wurde für alle Patentansprüche erstellt

| Recherchenort | Abschlußdatum der Recherche | Prüfer |
|---|---|---|
| DEN HAAG | 30-05-1990 | FEUER F.S. |

EPO FORM 1503 03.82 (P0403)